# EUROPÄISCHE PATENTSCHRIFT

(11) **EP 0 810 704 B1**
(45) Veröffentlichungstag und Bekanntmachung des Hinweises auf die Patenterteilung: **24.01.2001**
(21) Anmeldenummer: 97108562.6
(22) Anmeldetag: 28.05.1997
(51) Int. Cl.: H02B 1/30, H02B 1/56, H05K 5/02, H05K 7/20

(54) **Wand für das Gehäuse oder die Tür eines Schrankes, insbesondere für elektrische oder elektronische Baugruppen**
Wall for the casing or the door of a cabinet, especially for electric or electronic assemblies
Paroi du boîtier ou de la porte d'une armoire, notamment destinée à des assemblages électriques ou électroniques

(30) Priorität: 01.06.1996 DE 29609776 U
(43) Veröffentlichungstag der Anmeldung: 03.12.1997
(73) Patentinhaber: KRONE GmbH, 14167 Berlin (DE)
(72) Erfinder: Dehling, Helmut, 46286 Dorsten (DE); Nicolai, Norbert, Dr., 46282 Dorsten (DE); Osterholt, Gerd, 46286 Dorsten (DE); Adolf, Rudolf, 45631 Waltrop (DE)

(56) Entgegenhaltungen:
- EP-A- 0 262 431
- DE-A- 3 614 725
- DE-U- 8 309 697

## Beschreibung

Die Erfindung betrifft eine Gehäusewand für das Gehäuse und/oder die Tür eines Schrankes, insbesondere LAN (Local Areal Network)- oder Kabelverzweigerschrankes zur Aufnahme elektrischer und/oder elektronischer Baugruppen, mit einer Gehäuseaußenwand und einer hiervon beabstandeten Gehäuseinnenwand, wobei die Gehäuseinnenwand als wärmeleitende Wand, insbesondere Platte vorgegebener Größe, ausgebildet ist.

Eine derartige Gehäusewand bzw. ein aus einer solchen Gehäusewand hergestellter Kabelverzweigerschrank ist aus der DE-PS 36 14 725 bekannt. Hier ist der Kabelverzweigerschrank mit einem Kabelverzweigergehäuse, welches als Haube ausgebildet ist und in der Gehäusevorderseite eine Montageöffnung aufweist, ausgeführt. In die Montageöffnung ist eine verriegelbare Klappe eingesetzt und zumindest der Klappe und Haubenrückwand sind innenseitig jeweils eine Trennwand mit vorgegebenem Abstand zugeordnet, wobei die zwischen den Trennwänden und einerseits der Klappe, andererseits der Haubenrückwand gebildeten Zwischenräume obere und untere Lüftungsöffnungen aufweisen. Die Trennwände sind als Leitbleche ausgebildet, welche auf Verstärkungsrippen, Randprofilen, Abstandhaltern oder dergleichen für die Klappe, die Haubenrückwand und das Haubendach montiert sind. Insgesamt wird hierdurch eine zusätzliche Wärmeabführung im Bereich der von erhöhten Außentemperaturen bzw. Sonneneinstrahlung bevorzugten beaufschlagten Gehäusewänden erreicht. Denn die Gehäuse- bzw. Haubenrückwand bilden gleichsam eine Doppelschale mit Kaminwirkung. Dadurch wird die durch erhöhte Außentemperaturen bzw. Sonneneinstrahlung bevorzugt im Bereich der Gehäusevorderseite und -rückseite sich entwickelnde Wärme unabhängig von der eigentlichen Gehäusebelüftung und -entlüftung einwandfrei abgeführt. Die bekannte Gehäusewand hat sich an sich bewährt, ist jedoch in fertigungstechnischer Hinsicht weiter entwicklungsfähig. Ebenso ist die Verlustwärmeableitung verbesserungsbedürftig, insbesondere wenn im Innern Bauteile bzw. Baugruppen angeordnet sind, welche beträchtliche Abwärme entwickeln. Das gilt umsomehr, falls auf Lüftungsöffnungen im Schrank verzichtet werden muß, insbesondere bei staubdichter Unterbringung der Baugruppen. - Hier setzt die Erfindung ein.

Der Erfindung liegt die Aufgabe zugrunde, eine Gehäusewand der eingangs beschriebenen Ausführungsform so weiter zu entwickeln, daß die Verlustwärmeabfuhr aus dem Innern eines Schrankes, insbesondere LAN- oder Kabelverzweigerschrankes zur Aufnahme elektrischer und/oder elektronischer Baugruppen, an die Umgebung deutlich verbessert ist, wobei sich die Gehäusewand zusätzlich an unterschiedliche Gegebenheiten, insbesondere hinsichtlich wechselnder Schrankbreiten und -tiefen einfach anpassen lassen soll.

Zur Lösung dieser Aufgabe schlägt die Erfindung bei einer gattungsgemäßen Gehäusewand für das Gehäuse und/oder die Tür eines Schrankes, insbesondere LAN- oder Kabelverzweigerschrankes zur Aufnahme elektrischer und/oder elektronischer Baugruppen vor, daß auf der Gehäuseinnenwand eine doppelwandige Paneelwand - vorzugsweise aus trennbar miteinander verbundenen Paneelen - befestigt ist, wobei die Paneelwand eine der Gehäuseinnenwand zugeordnete Paneelinnenwand und eine hiervon beabstandete Paneelaußenwand als Gehäuseaußenwand aufweist und aus einem schlecht wärmeleitenden Material besteht, und wobei von der Paneelinnenwand und der Paneelaußenwand dazwischenliegende Hohlräume eingeschlossen sind. Vorzugsweise sind die Paneele als Hohlprofilleisten ausgebildet und schließen als durchgängige Paneelkammern ausgebildete Hohlräume ein, wobei die Paneele und damit die Paneelkammern jeweils in Längserstreckung der Paneelwand angeordnet sind, und wobei die Paneelkammern endseitig der Paneele verschlossen oder offen ausgeführt sowie gegebenenfalls mit geschlossenzelligem Schaum gefüllt sind. - Durch diese Maßnahmen der Erfindung wird zunächst einmal erreicht, daß die Verlustwärmeabfuhr aus dem Innern eines Schrankes an die Umgebung deutlich verbessert ist. Denn die als wärmeleitende Platte ausgebildete Gehäuseinnenwand leitet zunächst einmal die im Innern des Gehäuses bzw. Schrankes entstehende Abwärme an die schlecht wärmeleitende Paneelwand weiter. Dabei wird die Temperatur der Paneelwand infolge eines beispielsweise durch die Paneelkammern hervorgerufenen Kamineffektes günstig beeinflußt bzw. reduziert. Denn im Falle, daß die Paneelkammern endseitig offen ausgeführt sind, kann die in der Regel niedrigere Umgebungstemperatur problemlos durch diese Paneelkammern hindurchströmen und erzeugt den bereits angesprochenen Kamineffekt. Dieser führt dazu, daß die Paneelwand hierdurch praktisch gekühlt und die von der wärmeleitenden Gehäuseinnenwand an diese abgegebene Verlustabwärme problemlos abgeführt werden kann. Auf der anderen Seite wird infolge der geringen Wärmeleitfähigkeit der Paneelwand erreicht, daß beispielsweise Sonneneinstrahlung keinen wesentlichen Einfluß auf die Gehäuseinnentemperatur ausüben kann. Denn die Paneelwand wirkt praktisch als Wärmedämmschicht. Dies gelingt besonders gut für den Fall, daß die Profilkammern oben und unten beispielsweise durch Stopfen verschlossen werden, so daß die stehende Luft in den Paneelkammern zusätzlich wärmedämmend wirken kann. Alternativ ist es auch möglich, die Paneelkammern mit geschlossenzelligem Schaum zur Wärmedämmung zu füllen. Jedenfalls wird durch die Kombination innen wärmeleitende Gehäuseinnenwand, außen wärmedämmende, doppelwandige schlecht wärmeleitende Paneelwand insgesamt erreicht, daß einerseits die Wärme aus dem Innenraum vorteilhaft an die Umgebung abgegeben wird, andererseits eine mögliche Erwärmung von außen durch intensive Sonneneinstrahlung verhindert wird. Dies ist besonders für den Fall wichtig, daß im Innern des Schrankes elektronische Baugruppen angeordnet sind, welche eine staubdichte Unterbringung erfordern. Denn in diesem Fall kann die von den elektronischen Baugruppen erzeugte Abwärme nicht durch Beund Entlüftungsschlitze abgeführt werden. In diesem Fall sieht man regelmäßig im Innern des Gehäuses einen Lüfter vor, welcher die umgewälzte Warmluft über die sich erwärmenden Gehäusewände nach außen hin ableitet. Sollte die Verlustwärmeabfuhr bei einer solchen Vorgehensweise immer noch nicht ausreichen, so kann zusätzlich ein Klimagerät eingebaut werden. Denn es ist erforderlich, insbesondere bei der Unterbringung von elektronischen Baugruppen in Schränken dafür zu sorgen, daß die Temperatur im Innern des Schrankes einen bestimmten Wert nicht überschreitet. Dies gelingt in der Regel mit der erfindungsgemäßen Gehäusewand, ohne daß zusätzliche Klimatisierungsmaßnahmen ergriffen werden müssen. Folglich eignet sich diese Gehäusewand insbesondere zur Erstellung von LAN-Schränken.

Weiter ist vorteilhaft, daß sich die Gehäusewand relativ problemlos an unterschiedliche Gegebenheiten, insbesondere hinsichtlich zu verwirklichender Schrankbreiten und -tiefen anpassen läßt. Denn hierzu wird eine Gehäuseinnenwand als wärmeleitende Platte vorgegebener Größe ausgewählt und die Paneelwand mit den trennbar miteinander verbundenen Paneelen entsprechend angepaßt und mit der Paneelinnenwand verbunden. Dabei sind die herstellbaren Gehäusewandabmessungen von den Abmessungen der jeweiligen Paneele abhängig, bzw. lassen sich in durch die Paneelabmessung vorgegebenen Rastersprüngen herstellen. Denn die Gehäusewand bzw. Paneelwand besteht je nach gewünschter Größe aus einer bestimmten Anzahl miteinander verbundener Paneele. Wenn beispielsweise eine geringere Breite gewünscht sein sollte, werden entsprechend viele Paneele entfernt. Immer läßt sich die Gehäusewand bzw. die auf der Gehäuseinnenwand befestigte Paneelwand - im Rahmen der durch die Paneelbreite vor gegebenen Rastersprünge - an die jeweiligen Erfordernisse bzw. Schrankbreiten und -tiefen anpassen. Abgesehen davon ist die erfindungsgemäße Gehäusewand relativ leicht im Vergleich zu bekannten Gehäusewänden, welche beispielsweise aus zwei Metallplatten bestehen. Gleichzeitig wird nach wie vor eine ausreichende elektromagnetische Abschirmung durch die Gehäuseinnenwand für den Fall erreicht, daß diese aus Metall gefertigt ist. - Hierin sind die wesentlichen Vor teile der Erfindung zu sehen.

Weitere vorteilhafte Ausgestaltungen sind im folgenden aufgeführt. So sind die Paneelkammern bevorzugt als Doppel-L-Kammern ausgebildet, deren jeweilige kurzen L-Schenkel an der Gehäuseinnenwand anliegen und deren jeweilige langen L-Schenkel an einer Trennwand zusammenstoßen, wobei die jeweiligen Doppel-L-Kammern spiegelsymmetrisch in bezug auf die jeweilige Trennwand ausgebildet sind, und wobei die auf der Gehäuseinnenwand aufstehenden kurzen L-Schenkel benachbarter Doppel-L-Kammern einen weiteren Hohlraum zwischen der Paneelinnenwand und der Gehäuseinnenwand einschließen. Hierdurch wird insgesamt ein besonders funktionsgerechter und stabiler Aufbau der als Hohlprofilleisten ausgebildeten Paneele erreicht. Dabei wird insbesondere für den Fall, daß die Paneelkammern endseitig der Paneele verschlossen sind, zumindest durch die weiteren gebildeten Hohlräume ein Kamineffekt erzielt. Insofern ist immer eine ausreichende Kühlung der Paneele bzw. der Paneelwand gewährleistet. Weiter sind bevorzugt zwischen den Paneelen durchgängige in Längserstreckung der Paneelwand angeordnete, Trennkammern vorgesehen, welche als Rechteckprofilkammern mit jeweils von der Paneelaußenwand und der Paneelinnenwand begrenzten Schmalseitenflächen ausgebildet sind, wobei die Paneelaußenwand im Bereich der Trennkammern Längsnutkanäle zur Festlegung von Trennebenen zwischen den miteinander verbundenen Paneelen aufweist und die entlang der Trennebenen getrennten zweigeteilten Trennkammern mit ihren verbleibenden zwei U-Stegen zur Aufnahme von Verbindungsmitteln zwischen Gehäuseinnenwand und hierauf befestigter Paneelwand eingerichtet sind. Diese Trennkammern dienen folglich dazu, die Paneelwand an die entsprechend gewünschte Gehäusewandbreite bzw. -tiefe anpassen zu können. Denn die Paneele lassen sich im Bereich der jeweiligen Trennkammern in der Trennebene voneinander trennen. Weil die Trennkammern als Rechteckprofilkammern ausgebildet sind, entstehen bei einer solchen Trennung, welche regelmäßig mittels eines Schneidwerkzeuges durchgeführt wird, zwei U-Stege. Diese U-Stege können zur Aufnahme von Verbindungsmitteln eingesetzt werden, die zur Befestigung der Paneelwand auf der Gehäuseinnenwand dienen. Damit die Trennung einzelner Paneele voneinander und die Anpassung der Paneelwand an die gewünschten Abmessungen problemlos vonstatten geht, weist die Paneelaußenwand im Bereich der Trennkammern Längsnutkanäle zur Festlegung der Trennebenen zwischen den miteinander verbundenen Paneelen auf. Auf diese Weise lassen sich die Schnitte und damit die Trennung der Paneele voneinander ohne Zerstörung der Paneele vornehmen. Dies ist wichtig, damit die Paneele die gewünschte Wärmedämmfunktion bei der Gehäusewand übernehmen können. Aus gleichem Grund sind die Trennkammern auch relativ schmal ausgeführt, um bezüglich der Temperaturableitung negative Einflüsse zu vermeiden. Dies gelingt dadurch, daß die Paneelaußenwand bzw. die Paneelinnenwand die Schmalseitenflächen der Trennkammern bilden. Die Breitseitenflächen werden demgegenüber regelmäßig durch die benachbarten Hohlprofilleisten bzw. Paneele gebildet. Folglich entspricht die Länge der Breitseite der als Rechteckkammerprofil ausgebildeten Trennkammern im wesentlichen der Stärke der Paneelwand. Die Schmalseite ist dementsprechend kürzer als diese Paneelwandstärke ausgeführt. - Die Paneelwand kann auch aus Paneelwandteilen zusammengesetzt sein, welche über Nuten und Federn miteinander verbunden sind, wobei die Nuten und Federn zusammen mit U-Stegen zur Aufnahme von Verbindungsmitteln jeweils endseitig an den Schmalseiten der Paneelwandteile angeformt sind, und wobei die Paneelwandteile ihrerseits aus den Paneelen bestehen. Im Falle, daß die vorgenannten U-Stege ebenfalls zur Aufnahme von Verbindungsmitteln zwischen Gehäuseinnenwand und hierauf befestigter Paneelwand - wie die sich im Zuge der Teilung der Trennkammern bildenden U-Stege - eingerichtet sind, ist weiter vorgesehen, daß die Verbindungsmittel als in die U-Stege eingesetzte und mit der Paneelwand verbundene Befestigungsleisten ausgebildet sind, welche ihrerseits mit der Gehäuseinnenwand verbunden sind. Auf diese Weise läßt sich die Paneelwand auch für den Fall, daß diese aus Paneelwandteilen besteht, einwandfrei an der Gehäuseinnenwand befestigen. Denn diese Befestigung ist unabhängig davon, ob die Verbindungsmittel an einer Paneele oder an einem Paneelwandteil angreifen. Die wärmeleitende Platte ist vorzugsweise als U-förmige Metallplatte ausgeführt, wobei die Paneelwand zwischen den U-Schenkeln angeordnet und zumindest an den U-Schenkeln befestigt ist und die Paneelwand ist regelmäßig aus Kunststoff, insbesondere aus eingefärbtem PVC (Polyvinylclorid), gefertigt. Hierdurch kann auf aufwendige Lackierarbeiten verzichtet werden. Endlich ist die Verwendung einer oder mehrerer vorbeschriebener Gehäusewände zur Erstellung eines Gehäuses und einer Tür für einen Schrank mit einer umlaufenden Türdichtung vorgesehen, wobei die Türdichtung eine metallisierte Oberfläche oder ein eingebettetes Metallgewebe aufweist, welches zumindest teilweise in wärmeleitendem Kontakt mit der Gehäuseinnenwand steht.

Im folgenden wird die Erfindung anhand einer lediglich ein Ausführungsbeispiel darstellenden Zeichnung näher erläutert; es zeigen:
- Fig. 1: mehrere Horizontalschnitte durch eine erfindungsgemäße Gehäusewand unterschiedlicher Breite,
- Fig. 2: einen Horizontalschnitt durch einen unter Verwendung der erfindungsgemäßen Gehäusewand hergestellten Schrank,
- Fig. 3: einen schematischen Vertikalschnitt durch das Gehäuse eines Kabelverzweigerschrankes und
- Fig. 4: einen schematischen Vertikalschnitt durch ein Dach anderer Ausführungsform für einen Kabelverzweigerschrank.

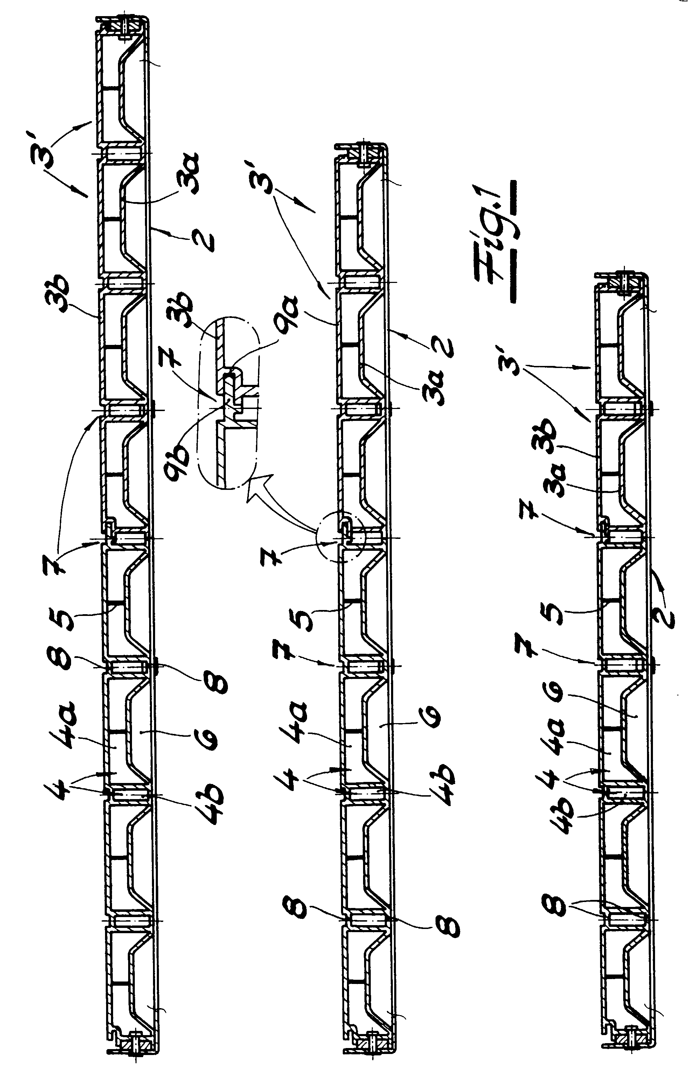

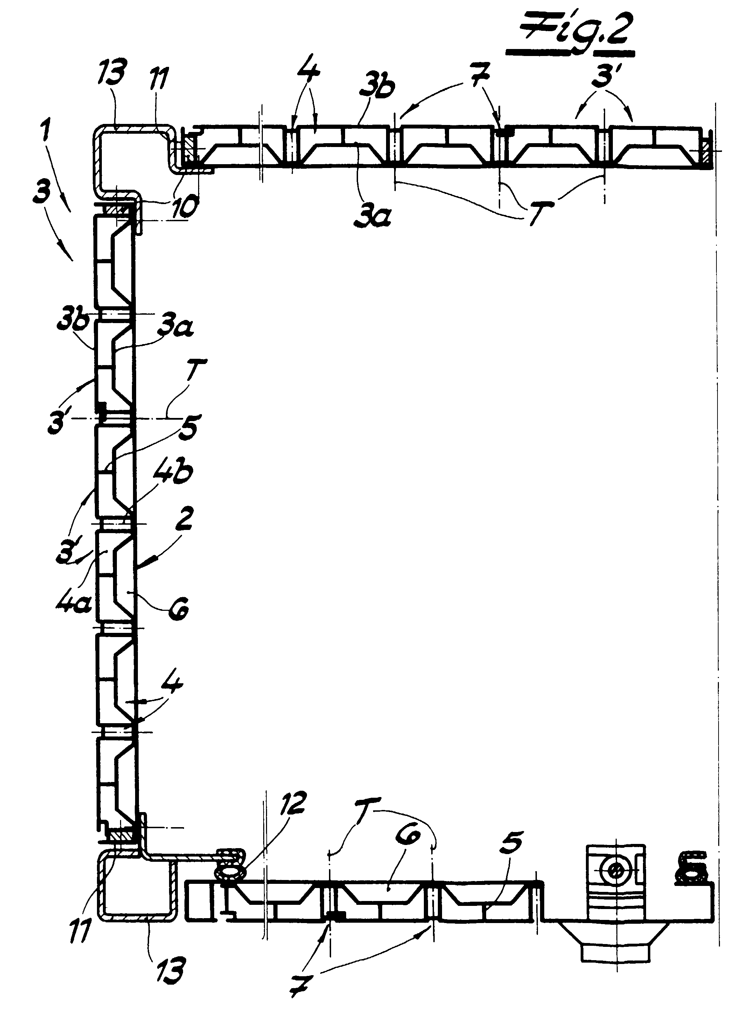

In den Fig. 1 und 2 ist eine Gehäusewand zur Erstellung eines Gehäuses und/oder einer Tür für einen Schrank, insbesondere LAN- oder Kabelverzweigerschrank zur Aufnahme elektrischer und/oder elektronischer Baugruppen gezeigt. Bei dem in der Fig. 2 dargestellten Schrank handelt es sich um einen LAN-Schrank. Diese Gehäusewand weist eine Gehäuseaußenwand 1 und eine hiervon beabstandete Gehäuseinnenwand 2 auf, wobei die Gehäuseinnenwand 2 als wärmeleitende Platte vorgegebener Größe ausgebildet ist. Auf der Gehäuseinnenwand 2 ist eine doppelwandige Paneelwand 3 aus trennbar miteinander verbundenen Paneelen 3' befestigt. Die Paneelwand 3 weist eine Paneelinnenwand 3a und eine hiervon beabstandete Paneelaußenwand 3b als Gehäuseaußenwand 1 auf.

Die Paneelwand 3 besteht aus einem schlecht wärmeleitenden Material, im Ausführungsbeispiel aus Kunststoff. Von der Paneelinnenwand 3a und der Paneelaußenwand 3b sind dazwischenliegende Hohlräume 4 eingeschlossen. Die Paneele 3' sind als durchgängige Hohlprofilleisten ausgebildet und schließen als durchgängige Paneelkammern 4a ausgebildete Hohlräume 4 ein. Die Paneele 3' und damit die Paneelkammern 4a sind jeweils in Längserstreckung der Paneelwand 3 angeordnet, wobei die Paneelkammern 4a im Ausführungsbeispiel endseitig der Paneele 3' verschlossen ausgeführt sind. Es ist aber auch möglich, daß die Paneelkammern 4a an dieser Stelle offen sind. Gegebenenfalls sind sie auch mit geschlossenzelligem Schaum gefüllt. Jedenfalls stellen die Paneele 3' insgesamt eine Wärmedämmschicht dar.

Die Paneelkammern 4a sind als Doppel-L-Kammern ausgeführt, deren kurzer L-Schenkel an der Gehäuseinnenwand 2 anliegt und deren jeweilige langen L-Schenkel an einer Trennwand 5 zusammenstoßen, wobei die jeweiligen Doppel-L-Kammern spiegelsymmetrisch in bezug auf die jeweilige Trennwand 5 ausgebildet sind. Die auf der Gehäuseinnenwand 2 aufstehenden kurzen L-Schenkel benachbarter Doppel-L-Kammern schließen einen weiteren Hohlraum 6 zwischen der Paneelinnenwand 3a und der Gehäuseinnenwand 2 ein. Für den Fall, daß die Paneelkammern 4a endseitig der Paneele 3' verschlossen sind, wird bei Erwärmung der Gehäuseinnenwand 2 und kälterer Umgebungsluft ein Kamineffekt in diesem Hohlraum 6 erzeugt. Im Falle, daß die Paneelkammern 4a offen ausgeführt sind, stellt sich dieser Kamineffekt zusätzlich in diesen Paneelkammern 4a ein. Jedenfalls wird insgesamt eine effiziente Verlustwärmeabfuhr von im Innern eines Schrankes entstehender Wärme durch die Gehäusewand erreicht. Gleichzeitig werden Erwärmungen durch intensive Sonneneinstrahlung im Innern des Schrankes durch die wärmedämmende Wirkung der Paneelwand 3 bzw. der Paneele 3' verhindert. Zwischen den Paneelen 3' sind durchgängige, in Längserstreckung der Paneelwand 3 angeordnete, Trennkammern 4b vorgesehen. Diese Trennkammern 4b sind Rechteckprofilkammern mit jeweils von der Paneelaußenwand 3b und der Paneelinnenwand 3a begrenzten Schmalseitenflächen ausgebildet, wobei die Paneelaußenwand 3b im Bereich der Trennkammern 4b Längsnutkanäle 7 zur Festlegung von Trennebenen T zwischen den miteinander verbundenen Paneelen 3' aufweist. Die entlang der Trennebenen T getrennten bzw. trennbaren zweigeteilten Trennkammern 4b sind mit ihren verbleibenden zwei U-Stegen 8 zur Aufname von Verbindungsmitteln zwischen Gehäuseinnenwand 2 und hierauf befestigter Paneelwand 3 eingerichtet. Die Trennebenen T sind insbesondere in der Fig. 1 durch strichpunktierte Linien angedeutet. Die Paneelwand 3 ist im Ausführungsbeispiel aus mehreren Paneelwandteilen zusammengesetzt, welche durch Nuten 9a und Federn 9b miteinander verbunden sind. Die Nuten 9a und Federn 9b sind zusammen mit U-Stegen 8 zur Aufnahme von Verbindungsmitteln jeweils endseitig an den Schmalseiten der Paneelwandteile angeformt. Die Paneelwandteile bestehen ihrerseits aus Paneelen 3'. Die U-Stege 8 an den Paneelwandteilen sind ebenso wie die U-Stege 8, welche sich im Zuge der Trennung zweier Paneelen 3' entlang der Trennebene T bilden, zur Aufnahme von Verbindungsmitteln eingerichtet. Diese Verbindungsmittel verbinden die Paneelwand 3 bzw. das entsprechende Paneelwandteil oder die Paneele 3' mit der Gehäuseinnenwand 2. Dies wird besonders anhand der Fig. 1 deutlich. Bei den Verbindungsmitteln handelt es sich im Ausführungsbeispiel um in die U-Stege 8 eingesetzte und mit der Paneelwand 3 verbundene Befestigungsleisten 10, welche ihrerseits mit der Gehäuseinnenwand 2 verbunden sind. Die Verbindung der Befestigungsleisten 10 mit der Paneelwand 3 erfolgt über Nieten, welche gleichzeitig die Verbindung zu der Gehäuseinnenwand 2 sicherstellen. Diese Gehäuseinnenwand 2 ist als wärmeleitende U-förmige Metallplatte ausgeführt, wobei die Paneelwand 3 zwischen den U-Schenkeln U-Schenkeln 11 angeordnet ist und zumindest an diesen 11 befestigt ist. Im Ausführungsbeispiel ist eine zusätzliche Befestigung der Paneelwand 3 durch Nieten im Bereich der U-Basis vorgesehen.

Schlußendlich ist in der Fig. 2 die Verwendung mehrerer vorbeschriebener Gehäusewände zur Erstellung des Gehäuses und der Tür für einen LAN-Schrank mit einer umlaufenden Türdichtung 12 gezeigt. Die einzelnen Gehäusewände sind über Eckprofile 13 miteinander verschraubt. Die Türdichtung ist auf eines dieser Eckprofile 13 aufgesteckt. Sie weist im Ausführungsbeispiel eine metallisierte Oberfläche oder ein eingebettetes Metallgewebe auf, welches zumindest teilweise in wärmeleitendem Kontakt mit der Gehäuseinnen wand 2 steht. Denn das Eckprofil 13 ist im Ausführungsbeispiel aus Metall gefertigt und stellt folglich eine Wärmebrücke zu der ebenfalls aus Metall bestehenden Gehäuseinnenwand 2 dar. Auf diese Weise wird nicht nur eine Verbesserung der elektromagnetischen Abschirmung des Schrankinnenraumes erreicht, sondern wird zusätzlich die Ableitung von im Schrankinnern erzeugter Verlustwärme verbessert.

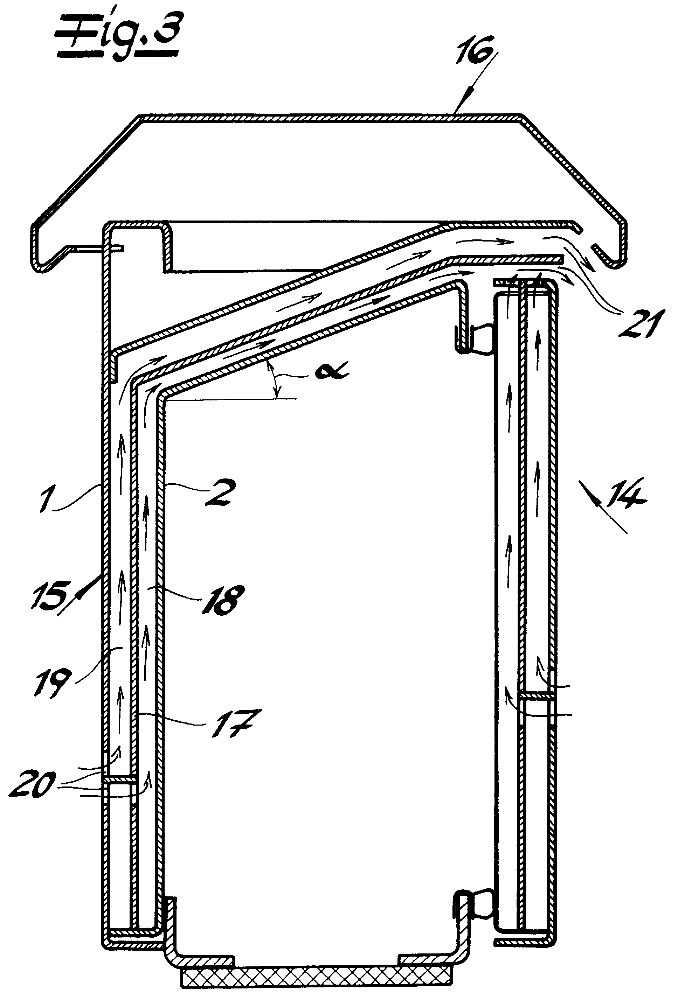

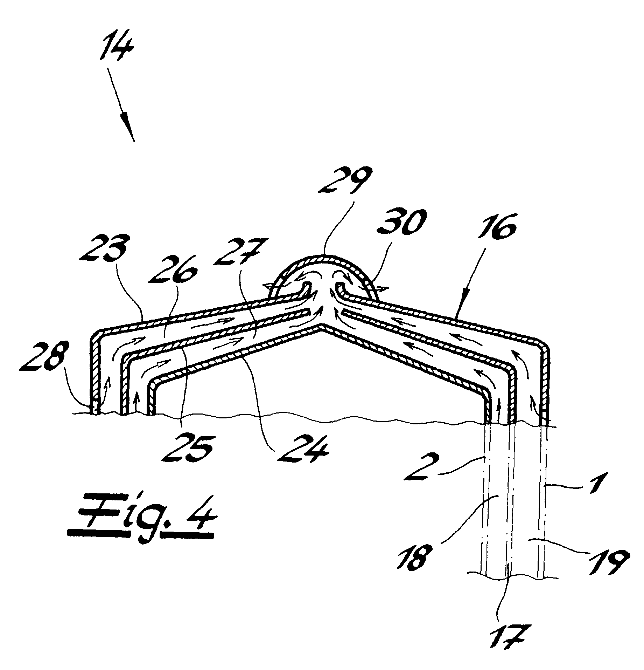

In den Fig. 3 und 4 ist ein Kabelverzweigerschrank 14 mit einem Gehäuse 15 und einem Dach 16 dargestellt, wobei die regelmäßig vorhandene Tür nicht gezeigt ist. Das Gehäuse 15 weist zumindest eine Gehäuseaußenwand 1 und eine Gehäuseinnenwand 2 auf. Zwischen der Gehäuseaußenwand 1 und der Gehäuseinnenwand 2 ist eine Zwischenwand 17 unter Bildung von einem inneren Zwischenraum 18 und einem äußeren Zwischenraum 19 angeordnet. Für die beiden Zwischenräume 18, 19 sind untere Lüftungsöffnungen 20 und obere Lüftungsöffnungen 21 vorgesehen. Auf diese Weise lassen sich zwei getrennte Kühlluftströme durch die Zwischenräume 18, 19 leiten. So kann der Kühlluftstrom im äußeren Zwischenraum 19 dazu genutzt werden, eine Erwärmung der Gehäuseaußenwand 1 durch Sonneneinstrahlung abzuführen, ohne daß eine Erwärmung der Gehäuseinnenwand 2 und damit der elektrischen und/oder elektronischen Baugruppen stattfindet. Ferner kann der Kühlluftstrom in dem inneren Zwischenraum jene Wärme abführen, welche die elektrischen und/oder elektronischen Baugruppen erzeugen. Grundsätzlich wird im Rahmen der Erfindung durch den mehrschichtigen Aufbau der Gehäusewand eine Isolierwirkung erreicht, wobei die Zwischenräume eine passive Kühlung infolge von durch Kaminwirkung auftretenden Luftströmen ebenso ermöglichen wie eine aktive Kühlung durch Anordnung von Luftfördereinrichtungen, z. B. Ventilatoren oder Gebläsen in diesen Zwischenräumen, welche also eine Luftströmung von den unteren Lüftungsöffnungen zu den oberen Lüftungsöffnungen oder umgekehrt von den oberen Lüftungsöffnungen zu den unteren Lüftungsöffnungen erzeugen können. - Weiter sieht die Erfindung vor, daß die Gehäuseaußenwand 1, die Gehäuseinnenwand 2, die Zwischenwand 17 und die beiden Zwischenräume 18, 19 von der einen Gehäuseseite zu der anderen Gehäuseseite, z. B. von der Gehäusehinterseite zu der Gehäusevorderseite oder umgekehrt von der Gehäusevorderseite zu der Gehäusehinterseite hin in eine Schräge mit vorgegebenem Neigungswinkel übergehen, wodurch die passive Kühlung und damit die Kühlluftströme infolge Kaminwirkung optimiert werden. Die Schräge kann das Dach 16 für den Kabelverzweigerschrank selbst bilden oder unterhalb des Daches 16, z. B. einer Haube angeordnet sein. Der Neigungswinkel α der Schräge beträgt maximal 45°, vorzugsweise 10° bis 20°. - Die unteren Lüftungsöffnungen 20 sind im Bereich zwischen dem unteren Drittel der betreffenden Gehäusewand 1, 2 und dem Dach 16 angeordnet. Insoweit geht die Erfindung von der Erkenntnis aus, daß insbesondere an windgeschützten Stellen, auf dunklen Böden (Asphalt) die Temperatur kurz oberhalb des Erdbodens verhältnismäßig hoch ist und mit steigender Höhe abfällt. Eine Luftabsaugung in Bodennähe zur Kühlung des Gehäuses könnte folglich bei hohen Außentemperaturen den gegenteiligen Effekt hervorrufen. Aus diesem Grunde befinden sich die Lüftungsöffnungen 20 für den Lufteinlaß deutlich oberhalb des Erdbodens, nämlich im Bereich des unteren Drittels der Gehäusewand, beispielsweise an der Gehäuserückwand und der Tür sowie an den Gehäuseseitenwänden. Stets werden die Kühlluftströme zur Erzielung einer höheren Kühleffektivität über den Dachbereich, dem wärmsten Teil des Kabelverzweigerschrankes 14, geleitet. Die Luftaustrittsöffnungen bzw. oberen Lüftungsöffnungen 21 befinden sich bei passiver Kühlung stets oberhalb der Lufteintrittsöffnungen bzw. unteren Lüftungsöffnungen 20.

Nach einer besonderen Ausführungsform der Erfindung ist vorgesehen, daß das Dach 16 eine Dachaußenfläche 23, eine Dachinnenfläche 24 und eine Dachzwischenfläche 25 unter Bildung von einem äußeren Zwischenraum 26 und einem inneren Zwischenraum 27 aufweist, wobei im Dachwandbereich Lufteintrittsöffnungen 28 und im Dachfirstbereich oder Dachzentrum von einer Wetterhaube 29 abgedeckte Luftaustrittsöffnungen 30 vorgesehen sind. Bei dieser Ausführungsform kann der Dachrand abgewinkelt sein, wobei die Dachflächen 23 bis 25 mit den Gehäusewänden 1, 2, 17 und die Zwischenräume 26, 27 des Daches 16 mit den Zwischenräumen 18, 19 der Gehäusewände 1, 2 und gegebenenfalls der Tür in Verbindung stehen.

Die Tür weist zweckmäßigerweise eine Türaußenwand, eine Türinnenwand und eine Zwischenwand unter Bildung ebenfalls eines äußeren Zwischenraumes und eines inneren Zwischenraumes auf, wobei für beide Zwischenräume untere und obere Lüftungsöffnungen wie bei der Gehäusewand vorgesehen sind. Das ist im einzelnen nicht dargestellt.

Nach einer bevorzugten Ausführungsform der Erfindung mit selbständiger Bedeutung ist vorgesehen, daß bei dem Gehäuse 15, gegebenenfalls aber auch bei dem Dach 16 und/oder bei der Tür die eingangs beschriebene Gehäusewand als Mehrkammerwand verwirklicht wird, wobei also auf der Gehäuseinnenwand 2 eine doppelwandige Paneelwand 3 befestigt ist, die Paneelwand 3 eine der Gehäusewand 2 zugeordnete Paneelinnenwand 3a und eine hiervon beabstandete Paneelaußenwand 3b als Gehäuseaußenwand 1 aufweist und aus einem schlecht wärmeleitenden Material besteht, und wobei von der Paneelinnenwand 3a und der Paneelaußenwand 3b dazwischenliegende Hohlräume 4, 6 eingeschlossen sind, welche die obenerwähnten Zwischenräume für die passive oder aktive Kühlluftführung bilden.

## Patentansprüche

1. Gehäusewand für das Gehäuse und/oder die Tür eines Schrankes, insbesondere LAN (Local Areal Network) - oder Kabelverzweigerschrankes zur Aufnahme elektrischer und/oder elektronischer Baugruppen, mit einer Gehäuseaußenwand (1) und einer hiervon beabstandeten Gehäuseinnenwand (2), wobei die Gehäuseinnenwand (2) als wärmeleitende Wand ausgebildet ist,
**dadurch gekennzeichnet,**
daß auf der Gehäuseinnenwand (2) eine doppelwandige Paneelwand (3) befestigt ist, wobei die Paneelwand (3) eine der Gehäuseinnenwand (2) zugeordnete Paneelinnenwand (3a) und eine hiervon beabstandete Paneelaußenwand (3b) als Gehäuseaußenwand (1) aufweist und aus einem schlecht wärmeleitenden Material besteht, und wobei von der Paneelinnenwand (3a) und der Paneelaußenwand (3b) dazwischen liegende Hohlräume (4, 6) eingeschlossen sind, wodurch bei einer Erwärmung der Gehäuseinnenwand (2) und einer kälteren Umgebungsluft zur Wärmeabfuhr ein Kamineffekt in zumindest einem der Hohlräume (4, 6) erzeugt wird.

2. Gehäusewand nach Anspruch 1, dadurch gekennzeichnet, daß die Paneelwand (3) aus trennbar miteinander verbundenen Paneelen (3') besteht.

3. Gehäusewand nach Anspruch 2, dadurch gekennzeichnet, daß die Paneele (3') als Hohlprofilleisten ausgebildet sind und als durchgängige Paneelkammern (4a) ausgebildete Hohlräume (4) einschließen, wobei die Paneele (3') und damit die Paneelkammern (4a) jeweils in Längserstreckung der Paneelwand (3) angeordnet sind, und wobei die Paneelkammern (4a) endseitig der Paneele (3') verschlossen oder offen ausgeführt sowie gegebenenfalls mit geschlossenzelligem Schaum gefüllt sind.

4. Gehäusewand nach Anspruch 3, dadurch gekennzeichnet, daß die Paneelkammern (4a) als Doppel-L-Kammern ausgebildet sind, deren kurzer L-Schenkel an der Gehäuseinnenwand (2) anliegt und deren jeweilige langen L-Schenkel an einer Trennwand (5) zusammenstoßen, wobei die jeweiligen Doppel-L-Kammern spiegelsymmetrisch in bezug auf die jeweilige Trennwand (5) ausgebildet sind, und wobei die auf der Gehäuseinnenwand (2) aufstehenden kurzen L-Schenkel benachbarter Doppel-L-Kammern einen weiteren Hohlraum (6) zwischen der Paneelinnenwand (3a) und der Gehäuseinnenwand (2) einschließen.

5. Gehäusewand nach einem der Ansprüche 2 bis 4, dadurch gekennzeichnet, daß zwischen den Paneelen (3') durchgängige, in Längserstreckung der Paneelwand (3) angeordnete, Trennkammern (4b) vorgesehen sind, welche als Rechteckprofilkammern mit jeweils von der Paneelaußenwand (3b) und der Paneelinnenwand (3a) begrenzten Schmalseitenflächen ausgebildet sind, wobei die Paneelaußenwand (3b) im Bereich der Trennkammern (4) Längsnutkanäle (7) zur Festlegung von Trennebenen (T) zwischen den miteinander verbundenen Paneelen (3') aufweist und die entlang der Trennebenen (T) getrennten zweigeteilten Trennkammern (4b) mit ihren verbleibenden zwei U-Stegen (8) zur Aufnahme von Verbindungsmitteln zwischen Gehäuseinnenwand (2) und hierauf befestigter Paneelwand (3) eingerichtet sind.

6. Gehäusewand nach einem der Ansprüche 1 bis 5, dadurch gekennzeichnet, daß die Paneelwand (3) aus Paneelwandteilen zusammengesetzt ist, welche über Nuten (9a) und Federn (9b) miteinander verbunden sind, wobei die Nuten (9a) und Federn (9b) zusammen mit U-Stegen (8) zur Aufnahme von Verbindungsmitteln jeweils endseitig an den Schmalseiten der Paneelwandteile angeformt sind, und wobei die Paneelwandteile ihrerseits aus den Paneelen (3') bestehen.

7. Gehäusewand nach Anspruch 5 oder 6, dadurch gekennzeichnet, daß die Verbindungsmittel als in die U-Stege (8) eingesetzte und mit der Paneelwand (3) verbundene Befestigungsleisten (10) ausgebildet sind, welche ihrerseits mit der Gehäuseinnenwand (2) verbunden sind.

8. Gehäusewand nach einem der Ansprüche 1 bis 7, dadurch gekennzeichnet, daß die als wärmeleitende Platte ausgebildete Gehäuseinnenwand (2) als U-förmige Metallplatte ausgeführt ist, wobei die Paneelwand (3) zwischen den U-Schenkeln (11) angeordnet und zumindest an den U-Schenkeln (11) befestigt ist.

9. Gehäusewand nach einem der Ansprüche 1 bis 8, dadurch gekennzeichnet, daß die Paneelwand (3) aus Kunststoff, insbesondere aus eingefärbtem PVC (Polyvinylclorid), gefertigt ist.

10. Verwendung einer oder mehrerer Gehäusewände nach einem der Ansprüche 1 bis 9 zur Erstellung eines Gehäuses und einer Tür für einen Schrank mit einer umlaufenden Türdichtung (12), wobei die Türdichtung (12) eine metallisierte Oberfläche oder ein eingebettetes Metallgewebe aufweist, welches zumindest teilweise in wärmeleitendem Kontakt mit der Gehäuseinnenwand (2) steht und gleichzeitig eine elektromagnetische Abschirmung des Schrankinnenraumes bewirkt.

11. Schrank, insbesondere Kabelverzweigerschrank (14) oder LAN (Local Areal Network)-Schrank, zur Aufnahme elektrischer und/oder elektronischer Baugruppen mit einem Gehäuse (15), einem Dach (16) und gegebenenfalls einer Tür, wobei das Gehäuse (15) zumindest eine Gehäuseaußenwand (1) und eine Gehäuseinnenwand (2) aufweist, dadurch gekennzeichnet, daß zwischen der Gehäuseaußenwand (1) und der Gehäuseinnenwand (2) eine Zwischenwand (17) unter Bildung eines inneren Zwischenraums (18) und eines äußeren Zwischenraums (19) angeordnet ist, und daß für die beiden Zwischenräume (18, 19) untere Lüftungsöffnungen (20) und obere Lüftungsöffnungen (21) vorgesehen sind.

12. Schrank nach Anspruch 11, dadurch gekennzeichnet, daß die Gehäuseaußenwand (1), die Gehäuseinnenwand (2), die Zwischenwand (17) und die beiden Zwischenräume (18, 19) von der einen Gehäuseseite zu der anderen Gehäuseseite in eine Schräge mit vorgegebenem Neigungswinkel (α) übergehen.

13. Schrank nach Anspruch 11 oder 12, dadurch gekennzeichnet, daß die Schräge das Dach (16) bildet oder unterhalb des Daches (16), z. B. einer Haube angeordnet ist.

14. Schrank nach einem der Ansprüche 11 bis 13, dadurch gekennzeichnet, daß der Neigungswinkel (α) der Schräge bis zu 45°, vorzugsweise 10° bis 20° beträgt.

15. Schrank nach einem der Ansprüche 11 bis 14, dadurch gekennzeichnet, daß die unteren Lüftungsöffnungen (20) im Bereich zwischen dem unteren Drittel der betreffenden Gehäusewand (1, 2) und dem Dach (16) angeordnet sind.

16. Schrank nach einem der Ansprüche 11 bis 15, dadurch gekennzeichnet, daß in dem einen oder anderen oder beiden Zwischenräumen (18, 19) Luftfördereinrichtungen (22), z. B. Ventilatoren oder Gebläse angeordnet sind, welche eine Luftströmung von den unteren Lüftungsöffnungen (20) zu den oberen Lüftungsöffnungen (21) oder von den oberen Lüftungsöffnungen (21) zu den unteren Lüftungsöffnungen (20) hin erzeugen.

17. Schrank nach einem der Ansprüche 11 bis 16, dadurch gekennzeichnet, daß das Dach (16) eine Dachaußenfläche (23), eine Dachinnenfläche (24) und eine Dachzwischenfläche (25) unter Bildung von einem äußeren Zwischenraum (26) und einem inneren Zwischenraum (27) aufweist, wobei im Dachrandbereich Lufteintrittsöffnungen (28) und im Dachfirstbereich oder Dachzentrum von einer Wetterhaube (29) abgedeckte Lufteintrittsöffnungen (30) vorgesehen sind.

18. Schrank nach einem der Ansprüche 11 bis 17, dadurch gekennzeichnet, daß der Dachrand abgewinkelt ist und die Dachflächen (23 bis 25) mit den Gehäusewänden (1, 2, 17) und die Zwischenräume (26, 27) des Daches (16) mit den Zwischenräumen (18, 19) der Gehäusewände (1, 2) in Verbindung stehen.

19. Schrank nach einem der Ansprüche 11 bis 18, dadurch gekennzeichnet, daß die Tür eine Türaußenwand, eine Türinnenwand und eine dazwischen angeordnete Zwischenwand unter Bildung eines äußeren Zwischenraumes und eines inneren Zwischenraumes aufweist und für beide Zwischenräume untere und obere Lüftungsöffnungen vorgesehen sind.

20. Schrank nach einem der Ansprüche 1 bis 19, dadurch gekennzeichnet, daß bei dem Gehäuse (15) und/oder bei dem Dach (16) und/oder bei der Tür auf der Gehäuseinnenwand (2) und/oder Dachinnenfläche (24) und/oder Türinnenwand eine doppelwandige Paneelwand (3) befestigt ist, wobei die Paneelwand (3) eine der Gehäuseinnenwand (2) und/oder Dachinnenfläche (24) und/oder Türinnenwand zugeordnete Paneelinnenwand (3a) und eine hiervon beabstandete Paneelaußenwand (3b) als Gehäuseaußenwand (1) und/oder Dachaußenfläche (23) und/oder Türaußenwand aufweist und aus einem schlecht wärmeleitenden Material besteht, und wobei von der Paneelinnenwand (3a) und der Paneelaußenwand (3b) dazwischenliegende Hohlräume (4, 6) eingeschlossen sind.

## Claims

1. Casing wall for the casing and/or the door of a cabinet, especially a LAN (Local Area Network) or cable distribution cabinet, for receiving electrical and/or electronic assemblies, having a casing outer wall (1) and a casing inner wall (2) at a distance from said outer wall, the casing inner wall (2) being designed as a heat-conducting wall, characterized in that a double-skin panelled wall (3) is fastened on the casing inner wall (2), the panelled wall (3) having a panelled inner wall (3a), assigned to the casing inner wall (2), and a panelled outer wall (3b), at a distance from said inner wall, as the casing outer wall (1), and consisting of a material with poor heat conduction, and cavities (4, 6) lying between the panelled inner wall (3a) and the panelled outer wall (3b) being enclosed by the said walls, whereby a flue effect is produced in at least one of the cavities (4, 6) when the casing inner wall (2) is heated and there is colder ambient air.

2. Casing wall according to Claim 1, characterized in that the panelled wall (3) comprises panels (3') detachably connected to one another.

3. Casing wall according to Claim 2, characterized in that the panels (3') are designed as hollow profiled strips and enclose cavities (4) designed as continuous panelled chambers (4a), the panels (3'), and consequently the panelled chambers (4a), being respectively arranged in the longitudinal extent of the panelled wall (3), and the panelled chambers (4a) being configured such that they are closed or open at the ends of the panels (3') and are possibly filled with closed-cell foam.

4. Casing wall according to Claim 3, characterized in that the panelled chambers (4a) are designed as double-L chambers, the short L legs of which bear against the casing inner wall (2) and the respective long L legs of which butt together at a separating wall (5), the respective double-L chambers being designed mirror-symmetrically in relation to the respective separating wall (5), and the short L legs of neighbouring double-L chambers that rise up from the casing inner wall (2) enclosing a further cavity (6) between the panelled inner wall (3a) and the casing inner wall (2).

5. Casing wall according to one of Claims 2 to 4, characterized in that provided between the panels (3') are continuous separating chambers (4b), which are arranged in the longitudinal extent of the panelled wall (3) and are designed as rectangular-profiled chambers with narrow side faces respectively bounded by the panelled outer wall (3b) and the panelled inner wall (3a), the panelled outer wall (3b) having in the region of the separating chambers (4) longitudinal grooved channels (7) for fixing separating planes (T) between the interconnected panels (3'), and the separating chambers (4b), divided into two and separated along the separating planes (T), being configured with their remaining two U-webs (8) for receiving connecting means between the casing inner wall (2) and panelled wall (3) fastened on the latter.

6. Casing wall according to one of Claims 1 to 5, characterized in that the panelled wall (3) is made up of panelled wall parts which are connected to one another by means of grooves (9a) and tongues (9b), the grooves (9a) and tongues (9b) together with U-webs (8) for receiving connecting means being respectively formed at the ends of the narrow sides of the panelled wall parts, and the panelled wall parts for their part comprising the panels (3').

7. Casing wall according to Claim 5 or 6, characterized in that the connecting means are designed as fastening strips (10) which are fitted into the U-webs (8), are connected to the panelled wall (3) and for their part are connected to the casing inner wall (2).

8. Casing wall according to one of Claims 1 to 7, characterized in that the casing inner wall (2), designed as a heat-conducting plate, is configured as a U-shaped metal plate, the panelled wall (3) being arranged between the U legs (11) and fastened at least on the U legs (11).

9. Casing wall according to one of Claims 1 to 8, characterized in that the panelled wall (3) is produced from plastic, in particular from coloured PVC (polyvinyl chloride).

10. Use of one or more casing walls according to one of Claims 1 to 9 for creating a casing and a door for a cabinet with a peripheral door seal (12), the door seal (12) having a metallized surface or an embedded metal mesh, which is at least partially in heat-conducting contact with the casing inner wall (2) and at the same time effects an electromagnetic shielding of the space inside the cabinet.

11. Cabinet, especially a cable distribution cabinet (14) or LAN (Local Area Network) cabinet, for receiving electrical and/or electronic assemblies, with a casing (15), a roof (16) and possibly a door, the casing (15) having at least a casing outer wall (1) and a casing inner wall (2), characterized in that an intermediate wall (17) is arranged between the casing outer wall (1) and the casing inner wall (2), forming an inner intermediate space (18) and an outer intermediate space (19), and in that lower ventilation openings (20) and upper ventilation openings (21) are provided for the two intermediate spaces (18, 19).

12. Cabinet according to Claim 11, characterized in that the casing outer wall (1), the casing inner wall (2), the intermediate wall (17) and the two intermediate spaces (18, 19) pass from one casing side to the other casing side in a slope at a predetermined angle of inclination (α).

13. Cabinet according to Claim 11 or 12, characterized in that the slope forms the roof (16) or is arranged underneath the roof (16), for example a shroud.

14. Cabinet according to one of Claims 11 to 13, characterized in that the angle of inclination (α) of the slope is up to 45°, preferably 10° to 20°.

15. Cabinet according to one of Claims 11 to 14, characterized in that the lower ventilation openings (20) are arranged in the region between the lower third of the casing wall (1, 2) concerned and the roof (16).

16. Cabinet according to one of Claims 11 to 15, characterized in that in one or other or both of the intermediate spaces (18, 19) there are arranged air-feeding devices (22), for example fans or blowers, which generate an air flow from the lower ventilation openings (20) to the upper ventilation openings (21) or from the upper ventilation openings (21) to the lower ventilation openings (20).

17. Cabinet according to one of Claims 11 to 16, characterized in that the roof (16) has a roof outer surface (23), a roof inner surface (24) and a roof intermediate surface (25), forming an outer intermediate space (26) and an inner intermediate space (27), air inlet openings (28) being provided in the region of the roof and air inlet openings (30) covered by a weather shroud (29) being provided in the region of the roof ridge or centre of the roof.

18. Cabinet according to one of Claims 11 to 17, characterized in that the edge of the roof is angled away and the roof surfaces (23 to 25) are in connection with the casing walls (1, 2, 17) and the intermediate spaces (26, 27) of the roof (16) are in connection with the intermediate spaces (18, 19) of the casing walls (1, 2).

19. Cabinet according to one of Claims 11 to 18, characterized in that the door has a door outer wall, a door inner wall and an intermediate wall arranged in between, forming an outer intermediate space and an inner intermediate space, and lower and upper ventilation openings are provided for both intermediate spaces.

20. Cabinet according to one of Claims 1 to 19, characterized in that, in the case of the casing (15) and/or in the case of the roof (16) and/or in the case of the door, a double-skin panelled wall (3) is fastened on the casing inner wall (2) and/or roof inner surface (24) and/or door inner wall, the panelled wall (3) having a panelled inner wall (3a), assigned to the casing inner wall (2) and/or roof inner surface (24) and/or door inner wall, and a panelled outer wall (3b), at a distance from said inner wall, as the casing outer wall (1) and/or roof outer surface (23) and/or door outer wall, and consisting of a material with poor heat conduction, and cavities (4, 6) lying between the panelled inner wall (3a) and the panelled outer wall (3b) being enclosed by the said walls.

## Revendications

1. Paroi de boîtier pour le boîtier et/ou la porte d'une armoire, en particulier d'une armoire de LAN (Local Area Network - réseau local) ou d'un boîtier de jonction, destinée à recevoir des assemblages électriques et/ou électroniques, avec une paroi extérieure (1) de boîtier et une paroi intérieure (2) de boîtier séparée de celle-ci, la paroi intérieure de boîtier (2) étant formée en tant que paroi conductrice de la chaleur,
caractérisée en ce que,
sur la paroi intérieure (2) du boîtier est fixée une paroi de panneau (3) double, la paroi de panneau (3) présentant une paroi intérieure de panneau (3a) associée à la paroi intérieure (2) du boîtier et une paroi extérieure de panneau (3b) écartée de celle-ci servant de paroi extérieure (1) du boîtier et se composant d'un matériau mauvais conducteur de la chaleur, et la paroi intérieure du panneau (3a) et la paroi extérieure du panneau (3b) renfermant entre elles des espaces creux (4, 6), un effet de cheminée étant obtenu, pour l'évacuation de la chaleur, au moins dans l'un des espaces creux (4, 6), lors d'un échauffement de la paroi intérieure (2) du boîtier et pour un air ambiant plus froid.

2. Paroi de boîtier selon la revendication 1, caractérisée en ce que la paroi de panneau (3) se compose de panneaux (3') reliés entre eux de manière séparable.

3. Paroi de boîtier selon la revendication 2, caractérisée en ce que les panneaux (3') sont formés en tant que nervures profilées creuses et renferment des espaces creux formés en tant que chambres à panneaux (4a) continues, les panneaux (3') et donc les chambres à panneaux (4a) étant à chaque fois disposés dans le prolongement longitudinal de la paroi de panneau (3), et les chambres à panneaux (4a) du côté de l'extrémité des panneaux (3') étant fermées ou ouvertes et étant éventuellement aussi remplies de mousse à alvéoles fermées.

4. Paroi de boîtier selon la revendication 3, caractérisée en ce que les chambres à panneaux (4a) sont formées en tant que chambres en L doubles, dont la branche courte du L s'applique contre la paroi intérieure (2) du boîtier et dont les branches longues respectives des L sont en butée l'une contre l'autre au niveau d'une paroi de séparation (5), les chambres en L doubles respectives étant formées avec une symétrie spéculaire par rapport à la paroi de séparation respective (5), et les branches courtes des L s'appliquant sur la paroi intérieure (2) du boîtier, de chambres en L doubles voisines, renfermant un autre espace creux (6) entre la paroi intérieure de panneau (3a) et la paroi intérieure (2) du boîtier.

5. Paroi de boîtier selon l'une quelconque des revendications 2 à 4, caractérisée en ce qu'entre les panneaux (3') sont prévues des chambres de séparation (4b) continues, disposées dans le prolongement longitudinal de la paroi de panneau (3), lesquelles sont formées en tant que chambres de profil rectangulaire avec, dans chaque cas, des faces latérales étroites limitées par la paroi extérieure de panneau (3b) et la paroi intérieure de panneau (3a), la paroi extérieure de panneau (3b) présentant, dans la région des chambres de séparation (4), des canaux en forme de gorges longitudinales (7) pour établir des plans de séparation (T) entre les panneaux (3') reliés ensemble et les chambres de séparations (4b) en deux parties séparées le long des plans de séparation (T) étant orientées avec leurs deux ailettes en U restantes (8) pour recevoir des moyens de connexion entre la paroi intérieure (2) du boîtier et la paroi de panneau (3) fixée par-dessus.

6. Paroi de boîtier selon l'une quelconque des revendications 1 à 5, caractérisée en ce que la paroi de panneau (3) est constituée de parties de paroi de panneau qui sont assemblées au moyen de rainures (9a) et de ressorts (9b), les rainures (9a) et les ressorts (9b) étant formés conjointement avec les ailettes en U (8) pour recevoir des moyens de connexion à chaque fois du côté de l'extrémité des côtés étroits des parties de paroi de panneau, et les parties de paroi de panneau se composant pour leur part des panneaux (3').

7. Paroi de boîtier selon la revendication 5 ou 6, caractérisée en ce que les moyens de connexion sont formés en tant que nervures de fixation (10) assemblées à la paroi de panneau (3) et utilisées dans les ailettes en U (8), lesquelles sont connectées pour leur part à la paroi intérieure (2) du boîtier.

8. Paroi de boîtier selon l'une quelconque des revendications 1 à 7, caractérisée en ce que la paroi intérieure (2) du boîtier formée en tant que plaque conductrice de la chaleur est réalisée en tant que plaque métallique en forme de U, la paroi de panneau (3) étant disposée entre les branches du U (11) et étant fixée au moins aux branches du U (11).

9. Paroi de boîtier selon l'une quelconque des revendications 1 à 8, caractérisée en ce que la paroi de panneau (3) est fabriquée en plastique, en particulier en PVC (chlorure de polyvinyle) coloré.

10. Utilisation d'une ou de plusieurs parois de boîtier selon l'une quelconque des revendications 1 à 9, pour la construction d'un boîtier et d'une porte pour une armoire avec une étanchéité de porte périphérique (12), l'étanchéité de porte (12) présentant une surface métallisée ou un tissu métallique noyé, qui est au moins partiellement en contact conducteur de la chaleur avec la paroi intérieure (2) du boîtier et réalise simultanément un blindage électromagnétique de l'espace intérieur de l'armoire.

11. Armoire, en particulier armoire pour un boîtier de jonction (14) ou pour un LAN (Local Area Network - réseau local), destinée à recevoir des assemblages électriques et/ou électroniques, avec un boîtier (15), un toit (16) et éventuellement une porte, le boîtier (15) présentant au moins une paroi extérieure (1) de boîtier et une paroi intérieure (2) de boîtier, caractérisée en ce qu'entre la paroi extérieure (1) de boîtier et la paroi intérieure (2) de boîtier est disposée une paroi intermédiaire (17) formant un espace intermédiaire interne (18) et un espace intermédiaire externe (19), et en ce que des ouvertures d'aération inférieures (20) et des ouvertures d'aération supérieures (21) sont prévues pour les deux espaces intermédiaires (18, 19).

12. Armoire selon la revendication 11, caractérisée en ce que la paroi extérieure (1) de boîtier, la paroi intérieure (2) de boîtier, la paroi intermédiaire (17) et les deux espaces intermédiaires (18, 19) passent d'un côté du boîtier à l'autre côté du boîtier suivant une pente d'angle d'inclinaison prédéfini (α).

13. Armoire selon la revendication 11 ou 12, caractérisée en ce que la pente forme le toit (16) ou est disposée sous le toit (16), par exemple d'une calotte.

14. Armoire selon l'une quelconque des revendications 11 à 13, caractérisée en ce que l'angle d'inclinaison (α) de la pente peut aller jusqu'à 45°, de préférence est compris entre 10° et 20°.

15. Armoire selon l'une quelconque des revendications 11 à 14, caractérisée en ce que les ouvertures d'aération inférieures (20) sont disposées dans la zone entre le tiers inférieur de la paroi de boîtier concernée (1, 2) et le toit (16).

16. Armoire selon l'une quelconque des revendications 11 à 15, caractérisée en ce que dans l'un ou l'autre ou dans les deux espaces intermédiaires (18, 19) sont disposés des dispositifs d'aération (22), par exemple des ventilateurs ou des soufflantes, qui produisent un courant d'air des ouvertures d'aération inférieures (20) aux ouvertures d'aération supérieures (21) ou des ouvertures d'aération supérieures (21) aux ouvertures d'aération inférieures (20).

17. Armoire selon l'une quelconque des revendications 11 à 16, caractérisée en ce que le toit (16) présente une surface extérieure de toit (23), une surface intérieure de toit (24) et une surface intermédiaire de toit (25), formant un espace intermédiaire extérieur (26) et un espace intermédiaire intérieur (27), des ouvertures d'entrée d'air (28) étant prévues dans la zone périphérique du toit et des ouvertures d'entrée d'air (30) recouvertes par une calotte de protection contre les intempéries (29) étant prévues dans la zone du faîte du toit ou du centre du toit.

18. Armoire selon l'une quelconque des revendications 11 à 17, caractérisée en ce que la périphérie du toit est inclinée et les surfaces du toit (23 à 25) sont connectées aux parois du boîtier (1, 2, 17) et les espaces intermédiaires (26, 27) du toit (16) sont connectés aux espaces intermédiaires (18, 19) des parois du boîtier (1, 2).

19. Armoire selon l'une quelconque des revendications 11 à 18, caractérisée en ce que la porte présente une paroi extérieure de porte, une paroi intérieure de porte et une paroi intermédiaire disposées entre elles formant un espace intermédiaire extérieur et un espace intermédiaire intérieur et des ouvertures d'aération inférieures et supérieures sont prévues pour les deux espaces intermédiaires.

20. Armoire selon l'une quelconque des revendications 1 à 19, caractérisée en ce que, dans le cas du boîtier (15) et/ou dans le cas du toit (16) et/ou dans le cas de la porte, une paroi de panneau (3) double est fixée sur la paroi intérieure (2) du boîtier et/ou la surface intérieure de toit (24) et/ou la paroi intérieure de la porte, la paroi de panneau (3) présentant une paroi intérieure (3a) de panneau associée à la paroi intérieure (2) du boîtier et/ou à la surface intérieure de toit (24) et/ou à la paroi intérieure de la porte et une paroi extérieure (3b) de panneau espacée de celle-ci en tant que paroi extérieure (1) de boîtier et/ou surface extérieure (23) de toit et/ou paroi extérieure de porte, et se compose d'un matériau mauvais conducteur de la chaleur, et des espaces creux (4, 6) étant formés par la paroi intérieure (3a) de panneau et la paroi extérieure (3b) de panneau entre celles-ci.
